# EUROPÄISCHE PATENTANMELDUNG

(11) **EP 0 890 902 A2**
(43) Veröffentlichungstag der Anmeldung: **13.01.1999**
(21) Anmeldenummer: 98112767.3
(22) Anmeldetag: 09.07.1998
(51) Int. Cl.: G06F 11/20

(54) **Redundanzschaltung für Halbleiterspeicher**

(30) Priorität: 10.07.1997 DE 19729579
(71) Anmelder: SIEMENS AKTIENGESELLSCHAFT, 80333 München (DE)
(72) Erfinder: Göbel, Holger, Dr., 80802 München (DE)

(57) **Zusammenfassung**

Die Erfindung betrifft eine Redundanzschaltung für Halbleiterspeicher mit in Segmenten organisierten Wortleitungen (WL), bei der bei Auftreten einer defekten Wortleitung (defect WL) in einem Segment (segment 8, 9, 10) mittels den jeweiligen Segmenten zugeordneten Fuse-Sets (10, 11) durch Inter-Segment-Redundanz eine redundante Wortleitung (Red. WL) im gleichen oder in einem anderen Segment durch ein Segmentauswahlsignal (RPDZ') aktivierbar ist. Das Segmentauswahlsignal (RPDZ') wird durch Auswertung des Ausgangssignals der Fuse-Sets direkt erzeugt.

## Beschreibung

Die vorliegende Erfindung betrifft eine Redundanzschaltung für Halbleiterspeicher mit in Segmenten organisierten Wortleitungen, bei der bei Auftreten einer defekten Wortleitung in einem Segment mittels den jeweiligen Segmenten zugeordneten Fuse-Sets durch Inter-Segment-Redundanz eine redundante Wortleitung im gleichen oder in einem anderen Segment durch ein Segmentauswahlsignal aktivierbar ist.

Bei Halbleiterspeichern sind die Wortleitungen gewöhnlich in Segmenten organisiert. Bei der sogenannten Inter-Segment-Redundanz können bei Auftreten einer defekten Wortleitung redundante Wortleitungen sowohl aus dem gleichen Segment, in welchem die defekte Wortleitung vorliegt, als auch aus benachbarten Segmenten verwendet werden, um diese defekte Wortleitung zu ersetzen.

Ein bei der Inter-Segment-Redundanz auftretendes Problem liegt nun darin, daß gegebenenfalls die Aktivierung des Segments mit der defekten Wortleitung verhindert und statt dessen das Segment aktiviert werden soll, in welchem sich die redundante Wortleitung befindet. Dies kann gegebenenfalls auch das Segment mit der defekten Wortleitung sein, wenn in diesem Segment zusätzlich die redundante Wortleitung vorliegt.

Um nun keine Zugriffszeit zu verlieren, muß bei einer solchen Redundanzschaltung für Halbleiterspeicher die Dekodierung des Signals, das das zu aktivierende Segment auswählt, also die Dekodierung des Segmentauswahlsignales, sehr rasch erfolgen.

Bisher werden in bestehenden Redundanzschaltungen durch Auswertung von Fuse-Ausgangssignalen mit Hilfe der ursprünglichen Zeilenadressen Segmentauswahlsignale generiert, welche das Segment mit der redundanten Wortleitung angeben. Es ist hier also eine zusätzliche Logik-Stufe erforderlich, um das Fuse-Ausgangssignal mit der Adreßinformation zu verknüpfen.

Es ist nun **Aufgabe** der vorliegenden Erfindung, eine Redundanzschaltung für Halbleiterspeicher zu schaffen, die ohne solche zusätzliche Logik-Stufe die Erzeugung von Segmentauswahlsignalen bei Auftreten defekter Wortleitungen erlaubt.

Diese Aufgabe wird bei einer Redundanzschaltung für Halbleiterspeicher der eingangs genannten Art erfindungsgemäß dadurch gelöst, daß das Segmentauswahlsignal durch Auswertung des Ausgangssignals der Fuse-Sets erzeugbar ist. Dies geschieht in vorteilhafter Weise dadurch, daS bei Übereinstimmung einer angelegten Zeilenadresse mit der gefusten Adresse des einem Segment zugeordneten Fuse-Sets eine den Fuse-Sets nachgeordnete Schaltung ein der Adresse dieses Segments zugeordnetes Signal aktiviert, das ein aus der Zeilenadresse erzeugtes Segmentauswahlsignal überschreibt und die redundante Wortleitung aktiviert.

Die erfindungsgemaße Redundanzschaltung wandelt also die Ausgangssignale der Fuse-Sets direkt, d.h. ohne Zuhilfenahme von Zeilenadressen, in Segmentauswahlsignale um, so daS keine logische Verknüpfung von den Fuse-Ausgangssignalen mit der Adreßinformation notwendig ist und eine Logik-Stufe eingespart werden kann. Dadurch wird die Zugriffszeit trotz der flexiblen Inter-Segment-Redundanz nicht erhöht, und das zu aktivierende Segment kann durch das unmittelbar aus dem Fuse-Ausgangssignal erzeugte Segmentauswahlsignal sehr rasch dekodiert werden.

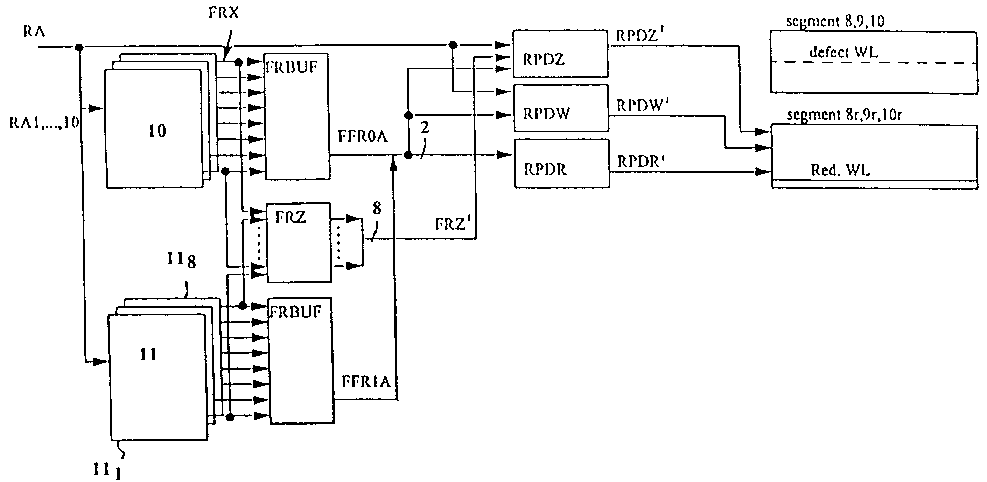

Nachfolgend wird die Erfindung anhand der Zeichnung näher erläutert, in deren einziger Figur ein Blockschaltbild der erfindungsgemäßen Redundanzschaltung für Halbleiterspeicher dargestellt ist.

In der Figur sind zunächst zwei Blöcke 10, 11 gezeigt, die jeweils aus acht Fuse-Sets für Segmente "000" bis "111" bestehen, wobei jeder Fuse-Set zehn Fuses und eine Masterfuse umfaßt. Die Masterfuse dient bekanntlich zur Aktivierung der Redundanz und zur Einschaltung des entsprechenden Blockes. Beispielsweise ist im Block 11 ein Fuse-Set 11₁ für Fuses für "000" zugeordnet, während ein Fuse-Set 11₈ für Fuses für "111" vorgesehen ist.

Am Eingang der Redundanzschaltung liegen Zeilenadressen RA bzw. RA1,...,RA10, die den Blöcken 10, 11 zugeführt sind. Die Zeilenadresse RA wird einem Segmentauswahlsignalblock RPDZ und einem Wortleitungsauswahlsignalblock RPDW zugeführt, die ein Segmentauswahlsignal RPDZ' bzw. ein Wortleitungsauswahl-Signal RPDW' generieren. Das zu aktivierende Segment, also beispielsweise ein Segment "segment 8, 9, 10", wird durch das Segmentauswahlsignal RPDZ' ausgewählt, welches aus den Zeilenadressen RA8, RA9, RA10 erzeugt ist. Welche Wortleitung WL innerhalb dieses Segmentes "segment 8, 9, 10" aktiviert wird, wird durch das Signal RPDW' bestimmt, das aus den Adressen RA0,...,RA7 abgeleitet ist.

An den Zeilendekodern liegen nach einem RAS-Befehl zunächst die Signale RPDW', also die Signale zur Auswahl einer Wortleitung innerhalb des aktivierten Segments, an. Unmittelbar danach wird eines der Segmentauswahlsignale RPDZ' aktiv, so daß die Aktivierung der entsprechenden Wortleitung WL beginnen kann.

Im Fall einer Inter-Segment-Redundanz kann es nun vorkommen, daß die redundante Wortleitung "Red. WL" in einem anderen Segment, also beispielsweise einem Segment "segment 8r, 9r, 10r", als dem durch die Zeilenadressen RA8, RA9, RA10 bestimmten Segment "segment 8, 9, 10" liegt. In diesem Fall muß dann ein neues Segmentauswahlsignal RPDZ' generiert werden, welches die Aktivierung der redundanten Wortleitung "Red. WL" in dem neuen Segment "segment 8r, 9r, 10r" startet. Gleichzeitig muß die Aktivierung der adressierten Wortleitung "defect WL" im Segment "segment 8, 9, 10" verhindert werden.

In einem zusammenhängenden Block des Halbleiterspeichers befinden sich beispielsweise acht Segmente, deren redundante Wortleitungen frei genutzt werden können, um defekte Wortleitungen in einem beliebigen Segment dieser acht Segmente mittels der Inter-Segment-Redundanz zu reparieren. Jedem Segment sind dabei genau zwei Fuse-Sets zugeordnet, d.h. es liegen zwei redundante Wortleitungen in jedem Segment vor.

Stimmt die angelegte Zeilenadresse RA mit einer der gefusten Adressen überein, liegt also eine defekte Wortleitung "defect WL" vor, so wird eines der 16 Ausgangssignale FRX der Blöcke 10, 11 der Fuses aktiv. Das bedeutet beispielsweise, daß das Signal FRX "niedrig" wird, wenn eine gefuste Adresse festgestellt wird. Die Signale FRX sind Blöcken FRBUF zugeführt, die als Puffer für die Fuse-Ausgangssignale FRX dienen und in denen geprüft wird, ob eine redundante Wortleitung "Red. WL" herangezogen werden muß, was dann der Fall ist, wenn ein Signal FRX niedrig ist. Die Blöcke FRBUF aktivieren ein Signal FFR0A bzw. FFR1A, so daß anstelle der ursprünglich adressierten Wortleitung "defect WL" die redundante Wortleitung "Red. WL" aktiviert wird. Im einzelnen sind die Signale FFR0A bzw. FFR1A "hoch", wenn eine Adresse gefust ist. Sie schalten über den Segmentauswahlsignalblock RPDZ bzw. über den Wortleitungsauswahlsignal-block RPDW das Signal RPDZ' zur Auswahl des Segmentes mit der defekten Wortleitung bzw. das Signal RPDW' zur Auswahl der Wortleitung "defect WL" ab und geben über einen Block RPDR die redundante Wortleitung "Red. WL" mit Hilfe eines Signals RPDR' frei. Das Signal RPDR' wählt also die redundante Wortleitung im Segment "segment 8r, 9r, 10r" aus.

Die Erzeugung des Segmentauswahlsignals RPDZ' erfolgt, indem die Ausgangssignale FRX der Blöcke 10, 11 ausgewertet werden, wie dies bereits oben erläutert wurde: Stimmt die angelegte Zeilenadresse RA beispielsweise mit der gefusten Adresse des dem Segment "segment 8r, 9r, 10r" zugeordneten Fuse-Sets überein, so wird in der Schaltung FRZ ein Signal FRZ' aktiviert, welches der Adresse 8r, 9r, 10r entspricht. Dieses Signal FRZ' wählt also bei Redundanz ein Segment und überschreibt in dem Segmentauswahlsignalblock RPDZ das regelmäßig gewählte Signal. Es ist beispielsweise hoch, falls keine Redundanz vorliegt, und niedrig, falls Redundanz auftritt. Das Signal FRZ' ist also dem Segmentauswahlsignalblock RPDZ zugeführt und überschreibt in diesem das aus der ursprünglichen Zeilenadresse 8, 9, 10 erzeugte Segmentauswahlsignal.

Es wird somit eine redundante Wortleitung "Red. WL" in dem Segment "segment 8r, 9r, 10r" aktiviert. Welche der beiden in diesem Segment vorhandenen redundanten Wortleitungen tatsächlich aktiviert wird, hängt davon ab, in welcher der beiden Gruppen von Fuse-Sets die Übereinstimmung zwischen angelegter und gefuster Adresse auftrat, was wiederum durch die Signale FFR0A bzw. FFR1A bestimmt wird.

## Patentansprüche

1. Redundanzschaltung für Halbleiterspeicher mit in Segmenten organisierten Wortleitungen (WL), bei der bei Auftreten einer defekten Wortleitung (defect WL) in einem Segment (segment 8, 9, 10) mittels den jeweiligen Segmenten zugeordneten Fuse-Sets (10, 11) durch Inter-Segment-Redundanz eine redundante Wortleitung (Red. WL) im gleichen oder in einem anderen Segment (segment 8, 9, 10; segment 8r, 9r, 10r) durch ein Segmentauswahlsignal (RPDZ') aktivierbar ist,
**dadurch gekennzeichnet,**
daß das Segmentauswahlsignal (RPDZ') durch Auswertung des Ausgangssignals (FRX) der Fuse-Sets (10, 11) erzeugbar ist.

2. Redundanzschaltung nach Anspruch 1,
**dadurch gekennzeichnet,**
daß bei Übereinstimmung einer angelegten Zeilenadresse (RA; RA1,....,RA10) mit der gefusten Adresse des einem Segment zugeordneten Fuse-Sets (10, 11) eine den Fuse-Sets nachgeschaltete Schaltung (FRZ) ein der Adresse dieses Segments zugeordnetes Signal (FRZ') aktiviert wird, das ein aus der Zeilenadresse erzeugtes Segmentauswahlsignal (RPDZ') überschreibt und die redundante Wortleitung (Red. WL) aktiviert.
